# EUROPÄISCHE PATENTSCHRIFT

(11) **EP 2 149 286 B1**
(45) Veröffentlichungstag und Bekanntmachung des Hinweises auf die Patenterteilung: **25.09.2013**
(21) Anmeldenummer: 08715509.9
(22) Anmeldetag: 23.02.2008
(51) Int. Cl.: H05K 5/00

(54) **GEHÄUSE MIT EINEM ELEKTRONISCHEN BAUTEIL**
HOUSING COMPRISING AN ELECTRONIC COMPONENT
BOÎTIER DOTÉ D'UN COMPOSANT ÉLECTRONIQUE

(30) Priorität: 19.03.2007 DE 102007013695; 14.06.2007 DE 102007027334
(43) Veröffentlichungstag der Anmeldung: 03.02.2010
(73) Patentinhaber: Conti Temic Microelectronic GmbH, 90411 Nürnberg (DE)
(72) Erfinder: TRENNER, Uwe, 90475 Nürnberg (DE); WIECZOREK, Matthias, 91233 Neunkirchen a. Sand (DE); HENNIGER, Jürgen, 91056 Erlangen (DE); KARRER, Helmut, 90762 Fürth (DE); WENK, Alexander, 91595 Burgoberach (DE); FALKNER, Roland, 91220 Schnaittach (DE); BUHL, Joachim, 90408 Nürnberg (DE)
(86) Internationale Anmeldenummer: PCT/DE2008/000317
(87) Internationale Veröffentlichungsnummer: WO 2008/113315

(56) Entgegenhaltungen:
- EP-A- 1 286 393
- DE-C1- 10 131 431
- DE-C1- 10 161 104
- DE-U- 7 417 008
- JP-A- 2003 174 269

## Beschreibung

Die Erfindung betrifft eine Anordnung eines elektronische Bauteils in einem Gehäuse, das Gehäuse und ein Verfahren zum Fixieren des Elektronischen Bauteils im Gehäuse gemäß den unabhängigen Ansprüchen.

Elektronische Bauteile, insbesondere Sensoren, werden im Bereich der Messtechnik, der allgemeinen Kontrolltechnik und auch insbesondere in der Kraftfahrzeugtechnik eingesetzt. Die Elektronisches Bauteilen arbeiten in der Umgebung von aggressiven Medien , wie Getriebeölen, sind hohen Temperaturschwankungen und hohen mechanischen Belastungen ausgesetzt. Sie erfassen unter anderem Größen wie Drücke, Drehzahlen und Abstände. Dazu ist es in der Regel er-forderlich, dass die Lage des elektronischen Bauteil zum zu sensierenden Teil exakt eingestellt ist und über die gesamte Lebensdauer auch eingehalten bleibt. Darüber hinaus darf eine bestimmte Kraft zum Fixieren des elektronischen Bauteils in seiner Aufnahme nicht überschritten werden , da dieses oft druckempfindlich ist und bei zu hohen einwirkenden Kräften beschädigt werden kann. Deshalb müssen die Abmessungen der elektronischen Bauteile enge Toleranzen einhalten, da beispielsweise bei einem Übermaß das elektronische Bauteil in die Aufnahme hineingepresst werden müsste und dabei Schaden nehmen könnte.

Die Druckschrift DE 101 61 104 C1 offenbart eine Anordnung einer Leiterplatte in einem Gehäuse, umfassend einen Deckel und ein Unterteil, wobei die Leiterplatte über den Rand des Unterteils hinausragt.

Bisher wurden elektronische Bauteile üblicherweise in einen als Aufnahme dienenden Vorumspritzling montiert, der Vorumspritzling in eine Spritzform eingelegt und anschließend wurde das Bauteilgehäuse in einem weiteren Arbeitsgang fertig gespritzt. Dies schließt viele Fertigungsschritte ein und ist zudem relativ materialintensiv.

Es ist daher eine Aufgabe der Erfindung, ein elektronisches Bauteil in einem Gehäuse der eingangs genannten Art derart anzuordnen, dass das elektronische Bauteil über die gesamte Lebensdauer bestimmungemäß funktioniert, wobei das elektronische Bauteil mit gewissen Abmessungstoleranzen behaftet sein darf.

Diese Aufgabe wird erfindungsgemäß gelöst durch eine Anordnung gemäß den Merkmalen des Anspruchs 1. Der Kern der Erfindung besteht darin, dass der Deckel des Gehäuses derart beschaffen ist, dass die Auswirkung einer Höhentoleranz des elektronisches Bauteils auf die Kraft, die der Deckel im montierten Zustand auf den nausübt, dahingehend kompensiert ist, dass die anliegende Kraft in einem vorgegebenen Kraftbereich liegt, insbesondere eine bestimmte Maximalkraft nicht übersteigt. Dadurch werden unter Beibehaltung der Funktionalität des elektronischen Bauteils über die gesamte Lebensdauer die Herstellungskosten für das elektronische Bauteil gesenkt.

Erfindungsgemäß ist die Kompensation der Höhentoleranz mittels eines vorgegebenen Elastizitätsmoduls des Deckels oder mittels eines vorgegebenen Dickenprofils des Deckels gegeben ist. Es wäre auch eine Kombination aus beiden Merkmalen denkbar. Der Deckel, in der Regel auch das Gehäuse, ist vorzugsweise aus Polyamid oder einem anderen Polymer. Das Elastizitätsmodul des Deckels liegt insbesondere im Bereich zwischen 3 GPa und 10Gpa. Die Dicke des Deckels schwankt vorteilhafterweise zwischen 0,15 mm und 3,0 mm. Es wäre auch denkbar, dass die Deckeldicke ein sich von der Mitte nach außen verjüngendes Profil besitzt, oder umgekehrt. Gemäß Anspruch 1 weist der Deckel eine Vertiefung auf, die als Solldehnstelle dient.

Eine weitere Aufgabe der Erfindung ist es, ein Gehäuse zu schaffen, das geeignet ist, ein elektronisches Bauteil mit gewissen Abmessungstoleranzen mit einfachen Mitteln über seine gesamte Lebensdauer sicher zu positionieren und zu fixieren.

Dies Aufgabe wird erfindungsgemäß gelöst durch ein Gehäuse gemäß den Merkmalen des Anspruchs 2.Vorteilhafterweise liegt die Kraft, die der Deckel auf das elektronische Bauteil ausübt, zwischen einer minimalen Kraft, die mindestens nötig ist, um das elektronische Bauteil im Gehäuse zu fixieren, und einer maximalen Kraft , die zur Sicherstellung der Funktionalität des elektronischen Bauteils nicht überschritten werden darf.

Gemäß den Ansprüchen 3 bis 5 kann der Deckel insbesondere planparallel, plan-konvex oder auch konkav-konvex ausgestaltet sein. Ein Vorteil einer in Richtung elektronisches Bauteil gewölbten Form des Deckels ist, dass dadurch eine zusätzliche Vorspannung erzielt wird.

Die Verbindung zwischen dem Deckel und dem Unterteil des Gehäuses kann gemäß Anspruch 6 zum Beispiel durch Verschrauben, Verschweißen, Kleben oder Verstemmen hergestellt sein.

Eine weitere Aufgabe der Erfindung ist es, ein Verfahren anzugeben, das geeignet ist, ein elektronisches Bauteil mit gewissen Abmessungstoleranzen in einem Gehäuse auch langfristig sicher zu positionieren und zu fixieren.

Diese Aufgabe wird erfindungsgemäß gelöst durch ein Verfahren gemäß den Merkmalen des Anspruchs 7.

Beim Verfahren zum Fixieren des elektronischen Bauteils im Gehäuse wird zunächst das elektronische Bauteil in das Unterteil des Gehäuses eingelegt. Anschließend wird der Deckel auf das Unterteil aufgelegt, wobei vorteilhafterwese eine vorgegebene Kraft kontrolliert auf den Deckel ausgeübt wird. Die Auswirkung einer Höhentoleranz des elektronischen Bauteils auf die Kraft wird durch die Beschaffenheit des Deckels derart kompensiert, dass die anliegende Kraft in einem Kraftbereich liegt und eine vor allem eine vorgegebene Maximalkraft nicht überschreitet. Der Kraftbereich liegt insbesondere zwischen einer minimalen Kraft, die mindestens nötig ist, um denn im Gehäuse zu fixieren, und einer maximalen Kraft , die zur Sicherstellung der Funktionalität des elektronischen Bauteils nicht überschritten werden darf. Die Verbindung zwischen dem Deckel und dem Unterteil des Gehäuses kann zum Beispiel durch Verschrauben, Verschweißen, Kleben oder Verstemmen hergestellt werden.

Bevorzugt kann der Deckel vor dem Aufsetzen auf das Unterteil erwärmt werden. Die Erwärmung kann partiell oder über die ganze Fläche des Deckels erfolgen. Der Temperaturverlauf über die Dicke des Deckels muss dabei nicht homogen sein. Bei der Erwärmung des Deckels sollte die Grenztemperatur zur plastischen Verformung nicht überschritten werden. Durch die Erwärmung wird das Material des Deckels weich und drückt ein elektronisches Bauteil, dessen Höhe an der oberen Toleranz liegt, mit einer verminderten Kraft in das Gehäuseunterteil und verhindert somit, dass das elektronische Bauteil beschädigt wird.

Weitere Vorteile und Merkmale der Erfindung ergeben sich aus der nachfolgenden Beschreibung von Beispielen anhand der Zeichnungen. Es zeigen:
- Fig.1: ein elektronisches Bauteil in einem Gehäuse mit dem Deckel vor der Montage,
- Fig.2: Gehäuse wie in Fig. 1, mit montiertem Deckel, und
- Fig.3: Gehäuse wie in Fig. 2, mit umlaufender Vertiefung im Deckel,
- Fig.4: Gehäuse wie in Fig. 3, von oben.

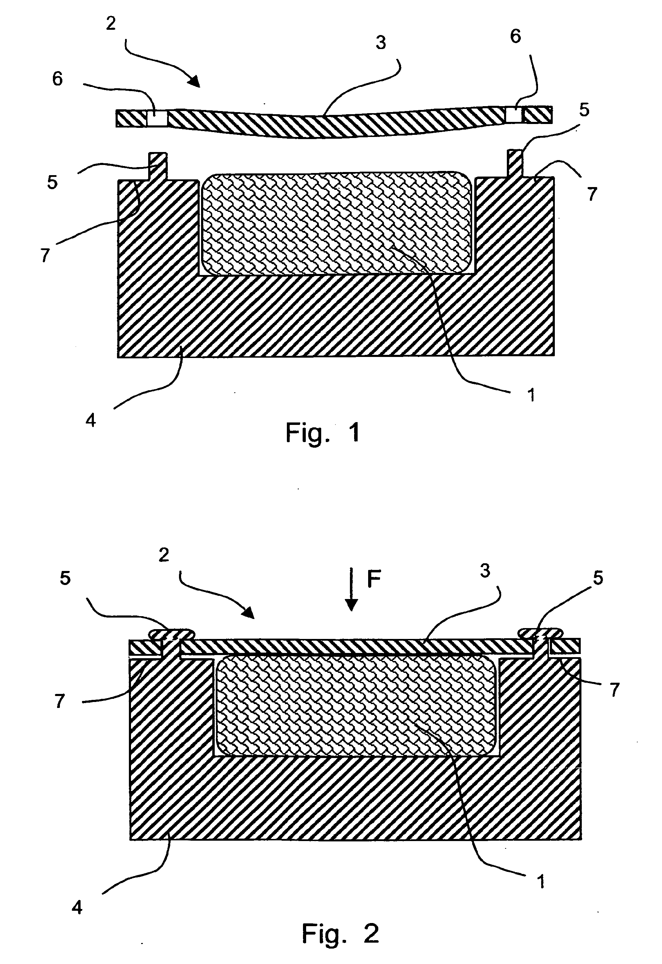

Fig. 1 zeigt einen Sensor 1 als Beispiel für ein elektronisches Bauteil im Unterteil 4 eines Gehäuses 2, wobei der Deckel 3 des Gehäuses 2 noch nicht montiert ist. Der Sensor 1 ragt über den Rand 7 des Unterteils 4 hinaus. Das Höhenmaß des Sensors 1 liegt demnach an der oberen Toleranzgröße. Am Rand 7 des Unterteils 4 sind mindestens zwei insbesondere zylinderförmige Zapfen 5 angeordnet. Der Deckel 3 hat ein konkav-konvexes Profil, wobei der konvexe Teil des Deckels 3 in Richtung des Sensor 1 zeigt. Der äußere Bereich des Deckels 3 sind wenigstens zwei Durchgangsöffnungen 6, die dazu vorgesehen sind, die Zapfen 7 aufzunehmen.

Fig. 2 zeigt den Sensor 1 im Gehäuse 2 mit montiertem Deckel 3. Vorzugsweise ist die Verbindung zwischen dem Deckel 3 und dem Unterteil 4 des Gehäuses 2 dichtend gegen die äußere Umgebung. Die Zapfen 5 sind in den entsprechenden Durchgangsöffnungen 6 des Deckels 3 angeordnet und verstemmt. Der Deckel 3 hat sich durch die Montage verformt. Das ehemals konkav-konvexe Profil ist jetzt planparallel. Der Deckel wirkt wie eine Feder. Dadurch fällt die Differenz der Kraft F auf den Sensor 1 in Abhängigkeit von der Höhentoleranz des Sensors 1 bei der Montage des Deckels 3 gering aus. Wird der Deckel 3 kraftüberwacht montiert, wird eine höhere Vorspannung auf den Sensor 1 erreicht. Dadurch wird einem Nachlassen der Kraft F durch alterungsbedingtes Relaxieren des Deckelmaterials entgegengewirkt.

Das Profil des Deckels könnte auch plan-konvex, planparallel oder meniskusförmig sein. Die federnde Wirkung des Deckels wird dann durch die Geometrie des Deckels 3 erreicht. Alternativ dazu kann die federnde Wirkung auch durch die Wahl des Elastizitätsmoduls des Deckelmaterials erreicht werden. Denkbar wäre auch eine Kombination aus geeigneter Deckelgeometrie und geeignetem Deckelmaterial.

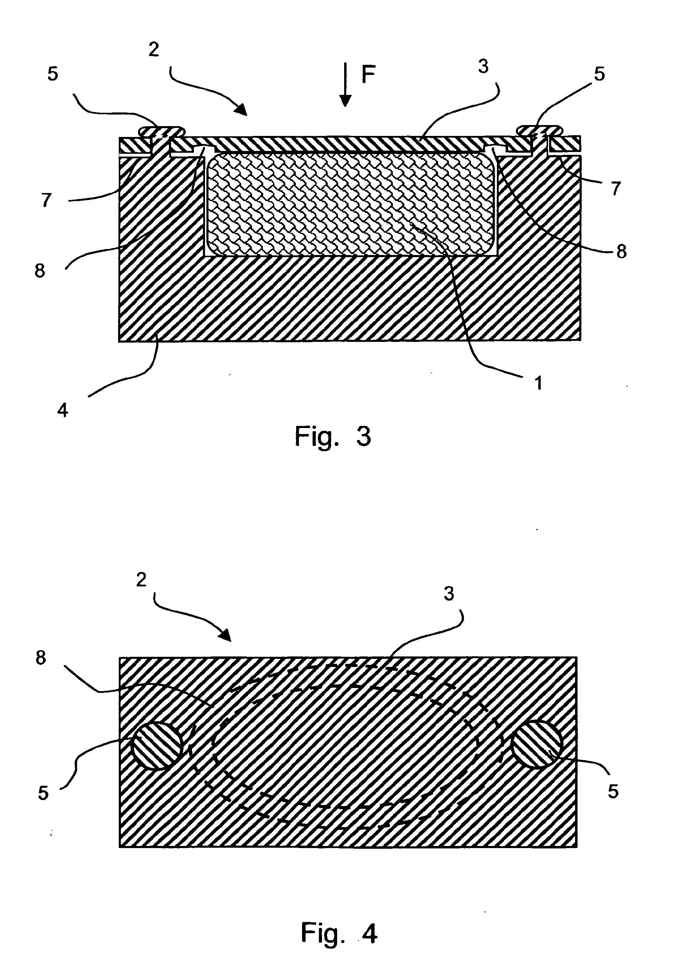

Fig. 3 zeigt eine erfindungsgemäße Anordnung, umfassend ein Gehäuse 2 wie in Fig. 2 mit einer umlaufenden Vertiefung 8 in der sensorseitigen Fläche des Deckel 3. Insbesondere verläuft die Vertiefung 8 im wesentlichen zwischen dem Sensor 1 und den Zapfen 5. Die Form und die Position der Vertiefung 8 kann aber auch variieren. So kann der Deckel 3 auch eine oder mehrere geradlinig, vorzugsweise parallel verlaufende Vertiefungen 8 aufweisen. Denkbar wäre auch eine U-förmig verlaufende Vertiefung 8. Die Vertiefung 8 kann auch auf der dem Sensor 1 abgewandten Fläche des Deckels 3 angeordnet sein.

Fig. 4 zeigt das Gehäuse 2 wie in Fig. 3, von oben.

Eine weitere, nicht gezeigte Möglichkeit, die Kraft F auf einen vorgegebenen Kraftbereich B zu beschränken, ist , den Deckel 3 vor der Montage zumindest partiell zu erwärmen. Der Deckel 3 kann dabei auch ein Standarddeckel ohne große Anforderungen an das Material oder die Geometrie sein. Vorteilhafterweise verteilt sich durch den weichen Deckel 3 die Kraft F gleichmäßig über den Sensor 1. Es wird insbesondere eine formschlüssige Fixierung des Sensors 1 durch den Deckel 3 möglich. Ein weiterer Vorteil dieser Ausführungsform ist, dass der Deckel 3 auf Anschlag montiert werden kann, das heißt, dass der Deckel 3 im montierten Zustand auf dem Rand 7 des Unterteils 4 aufliegt. Eine kostspielige Überwachung der Kraft kann bei der Montage des erwärmten Deckels 3 entfallen.

Die vorliegende Erfindung wurde anhand der vorstehenden Beschreibung so dargestellt, um das Prinzip der Erfindung und dessen praktische Anwendung bestmöglich zu erklären. Jedoch lässt sich die Erfindung bei geeigneter Abwandlung selbstverständlich in zahlreichen anderen Ausführungsformen realisieren.

### Bezugszeichenliste:

- 1: Sensor
- 2: Gehäuse
- 3: Deckel des Gehäuses
- 4: Unterteil des Gehäuses
- 5: Zapfen
- 6: Durchgangsöffnung im Deckel
- 7: Rand des Unterteils
- 8: Vertiefung im Deckel
- F: Kraft des Deckels auf den Sensor
- B: Kraftbereich für die Kraft F

## Patentansprüche

1. Anordnung eines elektronischen Bauteils (1) in einem Gehäuse (2) aus Kunststoff, umfassend einen Deckel (3) und ein Unterteil (4), wobei der Deckel (3) mit dem Unterteil (4) verbunden ist und der Deckel (3) nach der Montage auf das elektronische Bauteil (1), das über den Rand (7) des Unterteils (4) hinausragt, eine vorgegebene Kraft (F) ausübt, wobei der Deckel (3) derart beschaffen ist, dass die Auswirkung einer Höhentoleranz (dh) des elektronischen Bauteils (1) auf die anliegende Kraft (F) dahingehend kompensierbar ist, dass die anliegende Kraft (F) in einem vorgegebenen Kraftbereich (B) liegt, und wobei die Kompensation der Höhentoleranz (dh) mittels eines vorgegebenen Elastizitätsmoduls (E) des Deckels (3)und/oder mittels eines vorgegebenen Profils der Dicke (D) des Deckels (3) gegeben ist, **dadurch gekennzeichnet, dass**
der Deckel (3) wenigstens eine Vertiefung (8) als Solldehnstelle aufweist.

2. Gehäuse (2) nach Anspruch 1, **dadurch gekennzeichnet, dass** der Kraftbereich (B) zwischen einer minimalen Kraft (Fmin), die mindestens nötig ist, um das elektronische Bauteil (1) im Gehäuse (2) zu fixieren, und einer maximalen Kraft (Fmax) liegt, die zur Sicherstellung der Funktionalität des elektronischen Bauteils (1) einzuhalten ist.

3. Gehäuse (2) nach einem der vorhergehenden Ansprüche, **dadurch gekennzeichnet, dass** der Deckel (3) im wesentlichen planparallel ausgestaltet ist.

4. Gehäuse (2) nach einem der Ansprüche 1 bis 2, **dadurch gekennzeichnet, dass** der Deckel (3) plan-konvex ausgestaltet ist.

5. Gehäuse (2) nach einem der Ansprüche 1 bis 2, **dadurch gekennzeichnet, dass** der Deckel (3) konkav-konvex ausgestaltet ist.

6. Gehäuse (2) nach einem der vorhergehenden Ansprüche, **dadurch gekennzeichnet, dass** der Deckel (3) mittels Verschrauben, Verschweißen, Kleben oder Verstemmen mit dem Unterteil (4) verbunden ist.

7. Verfahren zum Fixieren eines elektronischen Bauteils (1) in einem Gehäuse (2) aus Kunststoff, wobei das Bauteil (1) über den Rand (7) des Unterteils (4) hinausragt, umfassend einen Deckel (3) und ein Unterteil (4), wobei die Kraft (F), die der Deckel (3) nach der Montage auf das elektronische Bauteil (1) ausübt, vorgegeben ist, mit den Schritten:
a) Bereitstellen des Gehäuses (2),
b) Einlegen des elektronischen Bauteils (1) in das Unterteil (4),
c) Aufsetzen des Deckels (3) auf das Unterteil (4),
d) Herstellen einer Verbindung zwischen dem Deckel (3) und dem Unterteil (4) derart, die Auswirkung einer Höhentoleranz (dh) des elektronischen Bauteils (1) auf die anliegende Kraft (F) durch die Beschaffenheit des Deckels (3) derart kompensiert wird, dass die anliegende Kraft (F) in einem Kraftbereich (B) liegt, wobei die Kompensation der Höhentoleranz (dh) mittels eines vorgegebenen Elastizitätsmoduls (E) des Deckels (3), und/oder mittels eines vorgegebenen Profils der Dicke (D) des Deckels (3) gegeben wird, **dadurch gekennzeichnet, dass** der Deckel wenigstens eine Vertiefung (8) als Solldehnstelle aufweist.

8. Verfahren zum Fixieren eines elektronisches Bauteils (1) nach Anspruch 7, **dadurch gekennzeichnet, dass** der Deckel (3) vor dem Aufsetzen auf das Unterteil (4) erwärmt wird.

9. Verfahren zum Fixieren eines elektronischen Bauteils (1) nach Anspruch 7 oder 8 **dadurch gekennzeichnet, dass die** dichte Verbindung zwischen dem Deckel (3) und dem Unterteil (4) mittels Verschrauben, Verschweißen, Kleben oder Verstemmen hergestellt wird.

## Claims

1. An arrangement of an electronic component (1) in a plastic case (2) comprising a cover (3) and a bottom part (4), wherein the cover (3) is connected to the bottom part (4) and the cover (3) applies a predetermined force (F) to the electronic component (1) after the mounting, said electronic component (1) projecting above the edge (7) of the bottom part (4), **wherein** the cover (3) is designed such that the effect of a height tolerance (dh) of the electronic component (1) on the applied force (F) can be compensated for to the effect that the applied force (F) is within a predetermined force range (B), and wherein the compensation for the height tolerance (dh) is given by means of a predetermined modulus of elasticity (E) of the cover (3) and/or by means of a predetermined profile of the thickness (D) of the cover (3), **characterized in that** the cover (3) has at least one recess (8) as a predetermined extension point.

2. The case (2) according to claim 1, **characterized in that** the force range (B) is between a minimum force (Fmin) needed to fix the electronic component (1) in the case (2) and a maximum force (Fmax) that must not be exceeded in order to ensure the functionality of the electronic component (1).

3. The case (2) according to any one of the preceding claims, **characterized in that** the cover (3) is essentially plane-parallel.

4. The case (2) according to any one of claims 1 to 2, **characterized in that** the cover (3) is plano-convex.

5. The case (2) according to any one of claims 1 to 2, **characterized in that** the cover (3) is concavo-convex.

6. The case (2) according to any one of the preceding claims, **characterized in that** the cover (3) is connected to the bottom part (4) by means of screwing, bonding, adhesive bonding or calking.

7. A method for fixing an electronic component (1) in a plastic case (2), wherein the component (1) projects above the edge (7) of the bottom part (4), comprising a cover (3) and a bottom part (4), wherein the force (F) that the cover (3) applies to the electronic component (1) after the mounting is predetermined, with the following steps:
a) providing the case (2),
b) putting the electronic component (1) into the bottom part (4),
c) putting the cover (3) onto the bottom part (4),
d) establishing a connection between the cover (3) and the bottom part (4) such that the effect of a height tolerance (dh) of the electronic component (1) on the applied force (F) is compensated for by the design of the cover (3) such that the applied force (F) is within a force range (B), wherein the compensation for the height tolerance (dh) is given by means of a predetermined modulus of elasticity (E) of the cover (3) and/or by means of a predetermined profile of the thickness (D) of the cover (3), **characterized in that** the cover has at least one recess (8) as a predetermined extension point.

8. The method for fixing an electronic component (1) according to claim 7, **characterized in that** the cover (3) is heated before it is put onto the bottom part (4).

9. The method for fixing an electronic component (1) according to claim 7 or 8, **characterized in that** the tight connection between the cover (3) and the bottom part (4) is established by means of screwing, bonding, adhesive bonding or calking.

## Revendications

1. Agencement d'un composant électronique (1) dans un boîtier (2) en matière plastique, comprenant un couvercle (3) et un élément de base (4), le couvercle (3) étant raccordé à l'élément de base (4), et le couvercle (3) exerçant, après le montage, une force (F) prédéfinie sur le composant électronique (1) qui dépasse du bord (7) de l'élément de base (4), le couvercle (3) étant constitué de telle sorte que la répercussion d'une tolérance de hauteur (dh) du composant électronique (1) sur la force (F) appliquée peut être compensée pour que la force (F) appliquée se situe dans une plage de force (B) prédéfinie, et la compensation de la tolérance de hauteur (dh) étant obtenue au moyen d'un module d'élasticité (E) prédéfini du couvercle (3) et/ou au moyen d'un profil prédéfini de l'épaisseur (D) du couvercle (3), **caractérisé en ce que** le couvercle (3) présente au moins une dépression (8) en tant qu'emplacement réservé pour la dilatation.

2. Boîtier (2) selon la revendication 1, **caractérisé en ce que** la plage de force (B) se situe entre une force minimale (Fmin) qui est au moins nécessaire pour fixer le composant électronique (1) dans le boîtier (2) et une force maximale (Fmax) qui doit être respectée pour garantir la fonctionnalité du composant électronique (1).

3. Boîtier (2) selon une des revendications précédentes, **caractérisé en ce que** le couvercle (3) est réalisé essentiellement de façon plane-parallèle.

4. Boîtier (2) selon une des revendications 1 à 2, **caractérisé en ce que** le couvercle (3) est réalisé de façon plane-convexe.

5. Boîtier (2) selon une des revendications 1 à 2, **caractérisé en ce que** le couvercle (3) est réalisé de façon concave-convexe.

6. Boîtier (2) selon une des revendications précédentes, **caractérisé en ce que** le couvercle (3) est raccordé à l'élément de base (4) par vissage, soudage, collage ou matage.

7. Procédé de fixation d'un composant électronique (1) dans un boîtier (2) en matière plastique, le composant électronique (1) dépassant du bord (7) de l'élément de base (4), comprenant un couvercle (3) et un élément de base (4), la force (F) qu'exerce sur le composant électronique (1) le couvercle (3) après le montage étant prédéfinie, comprenant les étapes suivantes :
a) fourniture du boîtier (2),
b) insertion du composant électronique (1) dans l'élément de base (4),
c) mise en place du couvercle (3) sur l'élément de base (4),
d) réalisation d'un raccordement entre le couvercle (3) et l'élément de base (4) de telle sorte que la répercussion d'une tolérance de hauteur (dh) du composant électronique (1) sur la force (F) appliquée peut être compensée par la constitution du couvercle (3) de telle sorte que la force (F) appliquée se situe dans une plage de force (B) prédéfinie, la compensation de la tolérance de hauteur (dh) étant obtenue au moyen d'un module d'élasticité (E) prédéfini du couvercle (3) et/ou au moyen d'un profil prédéfini de l'épaisseur (D) du couvercle (3), **caractérisé en ce que** le couvercle (3) présente au moins une dépression (8) en tant qu'emplacement réservé pour la dilatation.

8. Procédé de fixation d'un composant électronique (1) selon la revendication 7, **caractérisé en ce que** le couvercle (3) est chauffé avant d'être mis en place sur l'élément de base (4).

9. Procédé de fixation d'un composant électronique (1) selon la revendication 7 ou 8, **caractérisé en ce que** le raccordement étanche entre le couvercle (3) et l'élément de base (4) est réalisé par vissage, soudage, collage ou matage.
